# EUROPEAN PATENT SPECIFICATION

(11) **EP 3 507 793 B1**
(45) Date of publication and mention of the grant of the patent: **12.10.2022**
(21) Application number: 17845541.6
(22) Date of filing: 31.08.2017
(51) Int. Cl.: B06B 1/06, G10K 9/122

(54) **PIEZOELECTRIC ACTUATOR AND UNDERWATER ACOUSTIC TRANSDUCER**
PIEZOELEKTRISCHER AKTUATOR UND UNTERWASSERSCHALLWANDLER
ACTIONNEUR PIÉZOÉLECTRIQUE ET TRANSDUCTEUR ACOUSTIQUE SOUS-MARIN

(30) Priority: 31.08.2016 CN 201610798547
(43) Date of publication of application: 10.07.2019
(73) Proprietor: Beijing Supersonic Technology Co., Ltd., Beijing 100192 (CN)
(72) Inventor: WANG, Zhipeng, Beijing 100192 (CN); LIU, Guoxi, Beijing 100192 (CN); WANG, Penghui, Beijing 100192 (CN); SHI, Huaduo, Beijing 100192 (CN)
(74) Representative: Locas, Davide
(86) International application number: PCT/CN2017/100076
(87) International publication number: WO 2018/041239

(56) References cited:
- WO-A1-2013/100860
- CN-A- 102 568 464
- CN-A- 103 246 059
- CN-A- 103 841 499
- CN-A- 103 841 499
- CN-A- 104 137 285
- CN-A- 106 205 582
- CN-U- 206 134 235
- CN-U- 206 134 235
- CN-Y- 201 410 461
- JP-A- H11 136 198
- US-A1- 2012 161 581

## Description

### Cross Reference to Related Applications

The present application claims the priority of the Chinese Patent Application No. 201610798547.X, entitled "Actuating Device, Manufacturing Method Thereof, and Underwater Acoustic Transducer", filed with the Chinese Patent Office on August 31, 2016.

### Technical Field

The present invention relates to a piezoelectric actuator and an underwater acoustic transducer.

### Background Art

A transducer of Tonpilz design based on longitudinal vibration type has a design frequency ranging from a few kilohertz to dozens of kilohertz, and has found a wide range of application, including communication sonar, seafloor imaging sonar, active sonar for searching and tracking an underwater target, active sonar for monitoring harbor channels and sonar weapon and the like.

A traditional transducer of Tonpilz design of longitudinal vibration type consists of a lead zirconate titanate (PZT) piezoelectric ceramic stack of *d*₃₃ mode, a piston and a tail mass. The piezoelectric ceramic layers in a stack actuator are typically connected in parallel with each other, so as to reduce the drive voltage of the transducer. The piezoelectric stack produces, under the effect of the drive voltage, an axial stretching vibration, such that the piston produces corresponding vibrations for radiating acoustic waves toward water. During actual designs, pressures and stresses are typically exerted on the piezoelectric stack using a stress rod and a disc spring shim, hereby avoiding a pulling force exerted on the piezoelectric material and the connecting material, so as to improve the mechanical reliability of the transducer. For example, CN103841499A discloses a stacked piezoelectric round tube transducer, and WO2013100860A1 discloses a cost-effective single crystal multi-stake actuator.

A radially polarized PZT piezoelectric ceramic tube of *d*₃₁ mode (its electrodes are on the inner and outer surfaces) can also be used to generate acoustic waves. However, due to a weak transverse piezoelectric effect of PZT ceramics (its piezoelectric constant *d*₃₁ and electromechanical coupling coefficient *k*₃₁ are both relatively low), a PZT ceramic transducer driven in such a transverse mode does not have satisfactory sounding efficiency and acoustic source level.

Since lead-based relaxor single crystals have excellent transverse piezoelectric performance, single crystals of *d*₃₂ and *d*₃₁ transverse modes can be applied to the production of a high performance transducer of Tonpilz design. Comparatively thin and long single crystals will be used for such a design, which have a low bending and twisting strength. If no strengthening measure is taken, the single crystals would easily be damaged during use.

### Disclosure of the Invention

In order to overcome the above shortages, a first aspect of the present invention provides a piezoelectric actuator with piezoelectric reinforcements, so as to improve the bending strength and damage resistance according to claim 1.

A second aspect of the present invention provides an underwater acoustic transducer, wherein the piezoelectric actuator in the present invention is used as the drive part of this transducer, and thus the transducer has relatively good bending strength and damage resistance.

It is also described an example not forming part of the invention of a method for producing an underwater acoustic transducer, and the underwater acoustic transducer produced by this production method has relatively good bending strength and damage resistance.

Further, the inner piezoelectric assembly may include four second inner piezoelectric elements, wherein the four second inner piezoelectric elements successively adjoin each other along their axial-length edges to form a square pipe construction, and an outer surface of each of the second inner piezoelectric elements respectively rests on a corresponding inner surface of one of the first inner piezoelectric elements of the first inner piezoelectric assembly.

Further, the inner piezoelectric assembly may include four third inner piezoelectric elements and four fourth inner piezoelectric elements, wherein the four third inner piezoelectric elements successively adjoin each other along their axial-length edges to form a square pipe construction, and an outer side surface of each of the third inner piezoelectric elements s on a corresponding inner surface one of the second inner piezoelectric elements of the second inner piezoelectric assembly; and
the four fourth inner piezoelectric elements successively adjoin each other along their axial-length edges to form a square pipe construction, and the square pipe construction formed by the four fourth inner piezoelectric elements has its axial-length edges respectively abutting on a corresponding inner surface of the third inner piezoelectric elements of the third inner piezoelectric assembly.

Further, the inner piezoelectric assembly may include two first trusses, wherein both along their axial-length edges of each of the two first trusses are respectively in connection with and bonded onto the inner surfaces of opposite outer piezoelectric elements, and a circumferential length of both of the first trusses are parallel with another pair of opposite outer piezoelectric elements; or
the inner piezoelectric assembly includes two parallel second trusses, wherein both axial-length-wise edges of one of the two second trusses are in connection with and bonded onto the inner surfaces of two adjacent outer piezoelectric elements, while both axial-length edges of the other one of the second trusses are respectively in connection with and bonded onto the inner surfaces of the other two outer piezoelectric elements;
   or
the inner piezoelectric assembly includes four third trusses, wherein each of the third trusses is respectively in connection with and bonded onto the inner surfaces of two adjacent outer piezoelectric elements that correspond to the inner corners of the outer piezoelectric assembly.

Further, the outer piezoelectric elements and the inner piezoelectric elements may be of [011]-thickness polarized *d*₃₂ transverse mode single crystals of rectangular shape, of which the [100] crystal direction is in an axial direction of the piezoelectric actuator.

Further, the outer piezoelectric elements and the inner piezoelectric elements are [011]-thickness polarized *d*₃₁ transverse mode single crystals of rectangular shape, of which the [011] crystal direction is in an axial direction of the piezoelectric actuator.

Further, the outer piezoelectric elements and the inner piezoelectric elements are relaxor-type solid solution single crystal piezoelectric elements, wherein the components of the relaxor-type solid solution single crystal include: lead zinc niobate-lead titanate [Pb(Zn_{1/3}Nb_{2/3})O₃-PbTiO₃], lead magnesium niobate-lead titanate [Pb(Mg_{1/3}Nb_{2/3})O₃-PbTiO₃], lead magnesium niobate-lead zirconate titanate [Pb(Mg_{1/3}Nb_{2/3})O₃-PbZrO₃-PbTiO₃], lead indium niobate-lead magnesium niobate-lead titanate [Pb(In_{1/2}Nb_{1/2})O₃-Pb(Mg_{1/3}Nb_{2/3})O₃-PbTiO₃] or derivative components thereof.

Further, the piezoelectric actuator further may comprise a prestressing mechanism including a stress rod, a disc spring plate and a locknut, wherein the prestressing mechanism is configured such that the outer piezoelectric assembly and the inner piezoelectric assembly are under due compressive stress.

Further, the piezoelectric actuator further may comprise an anti-twist feature, of which the structure has a mechanical adaptability and which is configured to avoid the twisting of the piezoelectric actuator, while allowing the piezoelectric actuator to move freely linearly along its axial direction.

As to the first aspect mentioned above, an actuating device is provided, comprising: a first (outer) actuator and a piezoelectric reinforcement structure used for axially supporting the first (outer) actuator, wherein the reinforcement structure is arranged within the first (outer) actuator and is of an identical axial length of the first actuator, and the first actuator includes a plurality of first single crystal piezoelectric elements, of which the axial-length edges successively adjoin each other to form a closed polygonal-pipe construction.

Further, the piezoelectric reinforcement structure is a second actuator having an overall cross section smaller than that of the first actuator, wherein the second actuator includes a plurality of second single crystal piezoelectric elements, which successively adjoin each other along their axial-length edges to form a closed polygonal-pipe-like construction.

Further, a side surface of the second single crystal piezoelectric elements is attached to an inner surface of the first single crystal piezoelectric elements of the outer actuator.

Further, an axial-length edge of the second single crystal piezoelectric elements is attached to the inner surface of the first single crystal piezoelectric elements of the outer actuator.

Further, the piezoelectric reinforcement structure comprises at least one single crystal piezoelectric element pair, wherein said single crystal piezoelectric element pair includes two second single crystal piezoelectric elements arranged opposely, and the two second single crystal piezoelectric elements of the at least one single crystal piezoelectric element pair are symmetrically arranged inside the first actuator.

Further, it also comprises an edge guide for supporting the first actuator, wherein the first single crystal piezoelectric elements and the length-wise edges of the first single crystal piezoelectric elements are in connection with and bonded onto each other through the edge guide, the axial-length edges between the first single crystal piezoelectric elements and the second single crystal piezoelectric elements are in connection with and bonded onto each other through the edge guide, and the second single crystal piezoelectric elements and the axial-length edges of the second single crystal piezoelectric elements are in connection with and bonded onto each other through the aid of edge guides.

Further, the edge guide may be a connecting piece made of polycarbonate.

Further, the first single crystal piezoelectric element and the second single crystal piezoelectric element are both rectangular piezoelectric single crystals of transverse mode.

According to the second aspect mentioned above, an underwater acoustic transducer is provided, comprising: a piston, a tail mass and an actuating device according to any of the above items, wherein the actuating device includes a first connecting end and a second connecting end that are arranged axially, with the first connecting end being in connection with the piston and the second connecting end being in connection with the tail mass.

In the following a possible example of a production method of an actuating device is provided for producing the actuating device as mentioned above, the method comprising:
successively connecting the axial-length edges of a plurality of first single crystal piezoelectric elements to form a first actuator in a closed polygonal-pipe-like construction; and
arranging and bonding reinforcement structure made of single crystal piezoelectric element within the first actuator, such that the reinforcement structure supports the first actuator, wherein the reinforcement single crystals are of an identical axial length and thickness to the single crystal piezoelectric elements of the first actuator.

In combination with the above-mentioned technical solutions, the present invention can achieve the following beneficial effects:
The piezoelectric actuator provided in the present invention comprises an outer piezoelectric assembly and an inner piezoelectric assembly arranged in the internal of the outer piezoelectric assembly. The outer piezoelectric assembly includes four outer piezoelectric elements, wherein the four outer piezoelectric elements successively adjoin each other to form a square pipe construction. The inner piezoelectric assembly includes a plurality of inner piezoelectric elements, wherein the cut, the length (axial direction of the piezoelectric actuator) and the thickness (radial direction of the piezoelectric actuator) of the inner piezoelectric assembly are the same as those of the outer piezoelectric assembly, while the width thereof is smaller than the width of the outer piezoelectric assembly, and an edge (outer edge in the axial direction) or an outer surface of the inner piezoelectric assembly is in connection with and bonded onto the inner surface of the outer piezoelectric element, such that the inner piezoelectric assembly can support the outer piezoelectric assembly while having a piezoelectric effect, thus, the inner piezoelectric assembly and the outer piezoelectric assembly reinforce each other, hereby significantly improving the overall bending and breakage resistance of the piezoelectric actuator.

### Brief Description of the Drawings

In order to more clearly describe the technical solutions of the examples of the present invention, the drawings to be used in the examples will be simply presented below; and it shall be understood that the following drawings merely show certain examples of the present invention, and thus should not be construed as limiting the scope thereof, and for a person skilled in the art, further drawings could be obtained according to these drawings without inventive efforts.

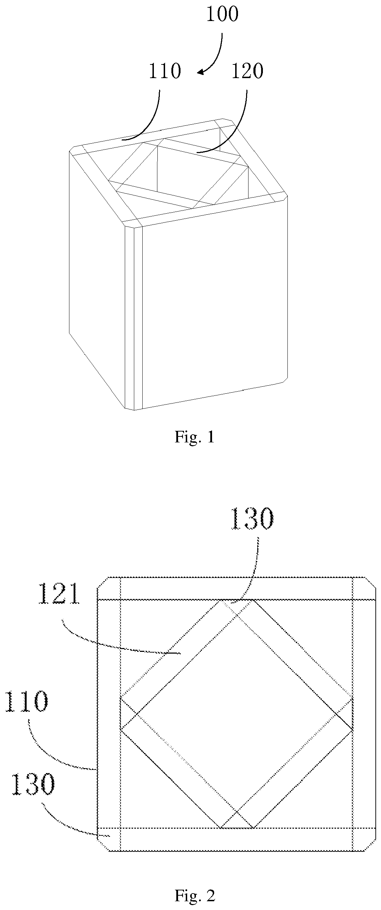

Fig. 1 is a structural schematic view of a piezoelectric actuator provided in a preferred example of the present invention, wherein this actuator comprises a large external square pipe formed by an outer piezoelectric assembly, and a smaller internal square pipe construction formed by an inner piezoelectric assembly, with an axial-length edge of the inner square pipe resting on an inner surface of the external square pipe;
Fig. 2 is a schematic section view of the piezoelectric actuator shown in Fig. 1;

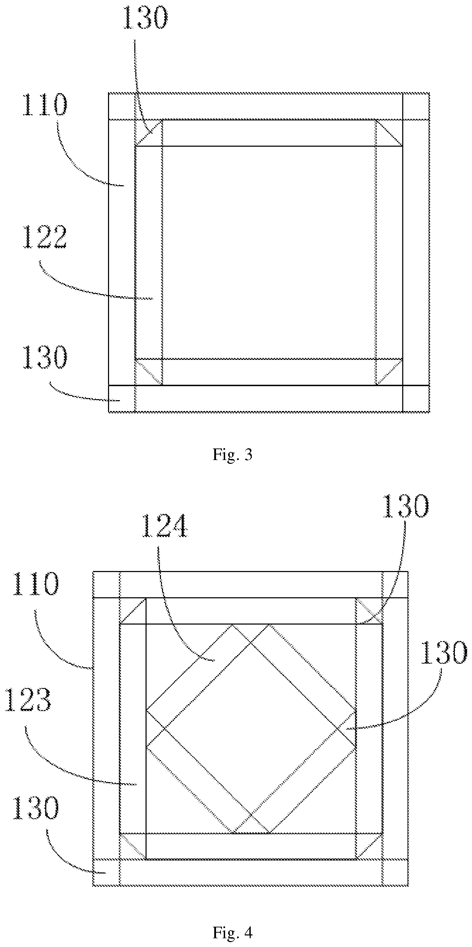

Fig. 3 is a structural schematic view of another piezoelectric actuator provided in a preferred example of the present invention, wherein this actuator comprises a large external square pipe formed by an outer piezoelectric assembly, and a smaller internal square pipe formed by an inner piezoelectric assembly, with an outer surface of the inner square pipe resting on an inner surface of the external square pipe;
Fig. 4 is a structural schematic view of yet another piezoelectric actuator provided in a preferred example of the present invention, wherein this actuator comprises an external square pipe, a middle square pipe and an inner square pipe, with an outer surface of the middle square pipe resting on an inner surface of the external square pipe and a length-edge of the internal square pipe resting on an inner surface of the middle square pipe;

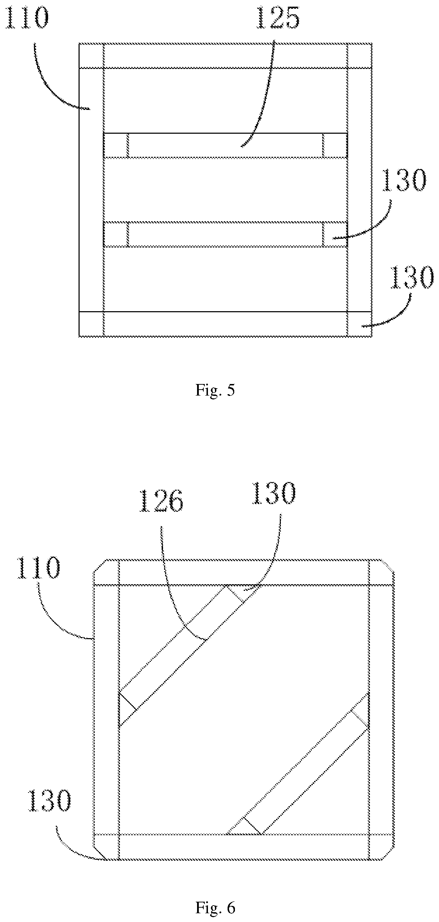

Fig. 5 is a structural schematic view of yet another piezoelectric actuator provided in a preferred example of the present invention, wherein this actuator comprises an external square pipe and two parallel trusses, with both ends of the two trusses respectively connecting two opposite outer piezoelectric elements;
Fig. 6 is a structural schematic view of further another piezoelectric actuator provided in a preferred example of the present invention, wherein this actuator comprises an external square pipe and two trusses, with both axial-length edges of the two trusses being respectively in connection with and bonded onto the inner surfaces of two adjacent outer piezoelectric elements;

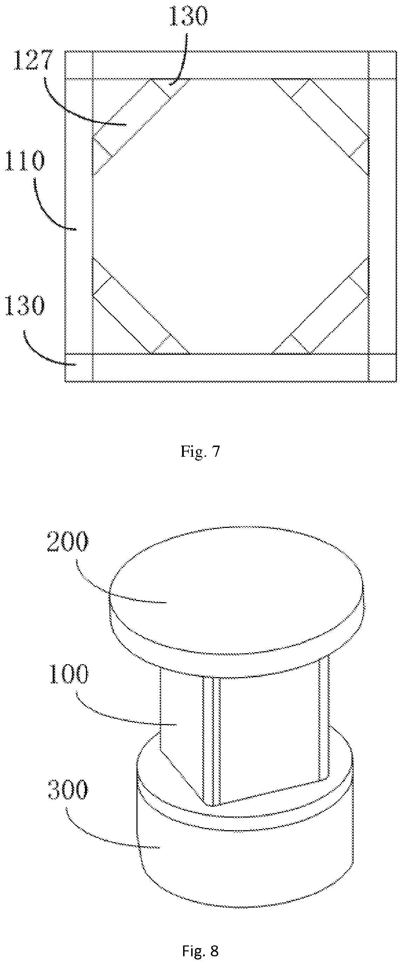

Fig. 7 is a structural schematic view of further another piezoelectric actuator provided in a preferred example of the present invention, wherein this actuator comprises an external square pipe and four trusses, with both axial-length edges of the four trusses being respectively in connection with and bonded onto the inner surfaces of two adjacent outer piezoelectric elements; and
Fig. 8 is a structural schematic view of an underwater acoustic transducer provided in a preferred example of the present invention, wherein this transducer comprises a piston, a tail mass and a drive element produced using the piezoelectric actuator in the present invention.

Legends: 100 - piezoelectric actuator; 110 - outer piezoelectric element; 120 - inner piezoelectric element; 121 - first inner piezoelectric element; 122 - second inner piezoelectric element; 123 - third inner piezoelectric element; 124 - fourth inner piezoelectric element; 125 - first truss; 126 - second truss; 127 - third truss; 130 - edge guide; 200 - piston; and 300 - tail mass.

### Detailed Description of the Embodiments

In order to make the objects, the technical solutions and the advantages of the examples of the present invention clearer, the technical solutions in the examples of the present invention will be clearly and comprehensively described below with reference to the figures of the examples of the present invention; and obviously, the described examples are merely some but not all examples of the present invention. Generally, the assemblies of the examples of the present invention that are described and shown here in the figures may be arranged and designed in various different configurations.

Thus, the following detailed description of the examples of the present invention that are provided in the figures merely represents chosen examples of the present invention, rather than being intended to limit the scope of the present invention for which protection is sought. Based on the examples in the present invention, further examples could be obtained by a person skilled in the art without inventive efforts. The scope of the invention is set forth in the accompanying claims.

It shall be noted that similar reference signs and letters represent similar items in the following figures, thus, once a certain item is defined in one figure, no further definition and explanation of this item is necessary in the subsequent figures.

In the description of the present invention, it shall be clarified that orientation or position relationships indicated by terms, such as "upper", "lower", "left", "right", "vertical", "horizontal", "inner", and "outer", are orientation or position relationships shown based on the figures, or orientation or position relationships in which a product of this invention is conventionally placed during use; the terms are used only for facilitating the description of the present invention and for simplifying the description, rather than indicating or implying that the specified device or element must have a specific orientation, and be constructed and operated in a certain orientation, and therefore cannot be construed as limiting the present invention. In addition, terms such as "first", "second", and "third" are used merely for purpose of differentiated description, and cannot be construed as indicating or implying to have importance in relativity.

In addition, terms such as "horizontal" and "vertical" do not mean that the components are required to be absolutely horizontal or pendulous, while in contrast, they may be slightly inclined. For example, the term "horizontal" only means that the direction thereof is more horizontal with respect to the term "vertical", rather than indicating that this structure must be completely horizontal, in contrast, this structure may be slightly inclined.

In the description of the present invention, it shall be clarified that, unless otherwise expressly specified and defined, terms such as "provide", "mount", "connect", and "connection" shall be construed in a broad sense. For example, it could be either a fixed connection, or a detachable connection, or an integrated connection; it could be either a mechanical connection, or an electrical connection; and it could be either a direct connection, or an indirect connection through an intermediate, or an inner communication between two elements. For a person skilled in the art, the specific meanings of the above-mentioned terms in the present invention could be construed in accordance with specific circumstances.

### First Example

In Fig. 1, a typical example of the piezoelectric actuator 100 in the present invention is shown, comprising an outer piezoelectric assembly and an inner piezoelectric assembly arranged in the internal of the outer piezoelectric assembly, wherein the inner piezoelectric assembly can realize a piezoelectric effect while having a supporting function, so as to improve the bending and breakage resistance of the piezoelectric actuator 100.

The outer piezoelectric assembly in the present invention includes four outer piezoelectric elements 110, wherein the four outer piezoelectric elements 110 are rectangular piezoelectric single crystal active elements having the same size which are successively adjoin each other along their axial-length edges to form a square pipe construction. The inner piezoelectric assembly includes a plurality of inner piezoelectric elements 120, and the inner piezoelectric elements 120 are rectangular piezoelectric single crystal active elements having the same size. The cut (crystal direction of the single crystal), the length (axial direction of the piezoelectric actuator 100) and the thickness (radial direction of the piezoelectric actuator 100) of the inner piezoelectric assembly are the same as those of the outer piezoelectric assembly, while the width thereof is smaller than the width of the outer piezoelectric assembly. Moreover, an edge (outer edge in the axial direction) or an outer surface of the inner piezoelectric assembly is in connection with and bonded onto an inner surface of the outer piezoelectric element 110, so as to realize a mutual support between the outer piezoelectric assembly and the inner piezoelectric assembly, hereby improving the overall bending and breakage resistance of the piezoelectric actuator 100.

Preferably, the present example provides a structural form of the piezoelectric actuator 100, specifically, referring to Figs. 1 and 2, it comprises four outer piezoelectric elements 110 and four first inner piezoelectric elements 121, wherein the four outer piezoelectric elements 110 successively adjoin each other along their axial-length edges to form an external square pipe construction, and respectively adjacent outer piezoelectric elements 110 are in connection with and bonded onto each other through an edge guide 130. The inner piezoelectric assembly includes four first inner piezoelectric elements 121, wherein the four first inner piezoelectric elements 121 successively adjoin each other along their axial-length edges to form an internal square pipe construction, and adjacent first inner piezoelectric elements 121 are respectively in connection with and bonded onto each other through the edge guide 130. Moreover, an axial-length edge of the square pipe construction formed by the first inner piezoelectric elements 121 rests on an inner surface of the outer piezoelectric elements 110; specifically, referring to Fig. 2 (schematic section view of the piezoelectric actuator 100 in the present preferable embodiment), the axial-length edge of the square pipe construction formed by the first inner piezoelectric elements 121 is in connection with the middle-line position of an inner surface of the outer piezoelectric element 110, and more preferably, the edge guide 130 connecting adjacent first inner piezoelectric elements 121 is configured to be a structure having a triangular cross section, wherein two adjacent sides of the triangle are respectively in connection with and bonded onto respective axial-length edges of two inner piezoelectric elements 121, while the other one side of the triangle rests on the inner surface of the outer piezoelectric element 110, and the resting position is the middle-line position of said outer piezoelectric element 110. The internal square pipe and the external square pipe construction in the present preferable embodiment reinforce and support each other, hereby improving the overall bending and breakage resistance of the piezoelectric actuator 100. Preferably, the present example provides another structural form of the piezoelectric actuator 100, specifically, referring to Fig. 3, the piezoelectric actuator 100 comprises four outer piezoelectric elements 110 and four second inner piezoelectric elements 122, wherein the four outer piezoelectric elements 110 adjoin each other along their axial-length edges to form an external square pipe construction, and adjacent outer piezoelectric elements 110 are in connection with and bonded onto each other through the edge guide 130. The inner piezoelectric assembly includes four second inner piezoelectric elements 122, wherein the four second inner piezoelectric elements 122 successively adjoin each other along their axial-length edges to form an internal square pipe construction, and adjacent second inner piezoelectric elements 122 are in connection with and bonded onto each other through the edge guide 130. Moreover, an outer side surface of the second inner piezoelectric elements 122 rests on and is bonded onto an inner side surface of the outer piezoelectric element 110. During operation, both the external square pipe and the inner square pipe actuators reinforce one another, significantly improving the overall bending and deformation resistance of the piezoelectric actuator 100.

Preferably, the present example provides another structural form of the piezoelectric actuator 100, specifically, referring to Fig. 4, the piezoelectric actuator 100 comprises four outer piezoelectric elements 110, four third inner piezoelectric elements 123 and four fourth inner piezoelectric elements 124. The four outer piezoelectric elements 110 successively adjoin each other along their axial-length edges to form an external square pipe construction, and adjacent outer piezoelectric elements 110 are in connection with and bonded onto each other through the edge guide 130. The four third inner piezoelectric elements 123 successively adjoin each other along their axial-length edges to form a middle square pipe construction, adjacent third inner piezoelectric elements 123 are in connection with and bonded onto each other through the edge guide 130, and the outer surfaces of the third inner piezoelectric elements 123 respectively rest on the inner surface of each of the outer piezoelectric elements 110. The four fourth inner piezoelectric elements 124 successively adjoin each other along their axial-length edges to form an internal square pipe construction, and adjacent fourth inner piezoelectric elements 124 are in connection with and bonded onto each other through the edge guide 130. Moreover, an axial-length edge of the internal square pipe construction formed by the four inner piezoelectric elements 120 rests on the inner surface of each of the third inner piezoelectric elements 123 of the middle square pipe construction. More preferably, the edge guide 130 connecting adjacent fourth inner piezoelectric elements 124 has a cross section in a triangular structure, wherein two sides of the triangle are respectively in connection with and bonded onto respective axial-length edges of two of the fourth inner piezoelectric elements 124, and the other one side of the triangular structure is in connection with and bonded onto the middle-line of the inner surface of the third inner piezoelectric elements 123. With such a construction, the three square-pipe actuators, the outer, the middle and the inner reinforce one another during use. The piezoelectric actuator 100 in the present preferable embodiment thus has relatively stronger bending and breakage resistance.

Preferably, the present example provides yet another structural form of the piezoelectric actuator 100, specifically, referring to Fig. 5, the piezoelectric actuator 100 comprises four outer piezoelectric elements 110 and two first trusses 125. The four outer piezoelectric elements 110 successively adjoin each other along their axial-length edges to form an external square pipe construction, and adjacent outer piezoelectric elements 110 are in connection with and bonded onto each other through the edge guide 130. Both ends of the two first trusses 125 are respectively in connection with and bonded onto the inner surfaces of two opposite outer piezoelectric elements 110. Moreover, the two first trusses 125 are parallel with the other pair of opposite outer piezoelectric elements 110. More specifically, both axial-length edges of the first trusses 125 are in connection with and bonded onto corresponding outer piezoelectric elements 110 through the edge guides 130, of which one side is in connection with and bonded onto the first truss 125 and the other side is in connection with and bonded onto the inner surface of an outer piezoelectric element 110. With said construction, the piezoelectric trusses reinforce the external square pipe actuator during use, significantly improving the overall bending and deformation resistance of the piezoelectric actuator 100.

Preferably, the present example provides yet another structural form of the piezoelectric actuator 100, specifically, referring to Fig. 6, the piezoelectric actuator 100 comprises four outer piezoelectric elements 100 and two second trusses 126. The four outer piezoelectric elements 110 successively adjoin each other along their axial-length edges to form an external square pipe construction, and the two trusses form a diagonal truss construction, wherein both axial-length edges of one of the second trusses 126 are in connection with and bonded onto the inner surfaces of two adjacent outer piezoelectric elements 110, and both axial-length edges of the other second truss 126 are respectively in connection with and bonded onto the inner surface of the other two adjacent outer piezoelectric elements 110. More specifically, both axial -length edges of one of the second trusses 126 are in connection with and bonded onto the inner surface of two adjacent outer piezoelectric elements 110 through the edge guides 130, and the cross-section of one of the second trusses 126 and the two connected adjacent outer piezoelectric elements 110 reveals the shape of an isosceles triangle. Preferably, the intersection point of the second truss 126 and the outer piezoelectric element 110 is an equal diversion point of one half of the outer piezoelectric element 110. Likewise, both length-edges of the other one of the second trusses 126 are respectively in connection with and bonded onto the inner surfaces of the other two adjacent outer piezoelectric elements 110 through the edge guides 130. Moreover, a cross-section of said other second truss 126 and the two connected adjacent outer piezoelectric elements 110 forms the shape of an isosceles triangle. In the present preferable embodiment, the two second trusses 126, functioning as a support beam, can effectively support the external square pipe construction, thereby significantly improve the overall bending and deformation resistance of the piezoelectric actuator 100.

Preferably, the present example provides yet another structural form of the piezoelectric actuator 100, specifically, referring to Fig. 7, the piezoelectric actuator 100 comprises four outer piezoelectric elements 110 and four third trusses 127. The four outer piezoelectric elements 110 successively adjoin each other along their axial-length edges to form an external square pipe construction, and each of the third trusses 127 is respectively in connection with and bonded onto the inner surfaces of two adjacent outer piezoelectric elements 110 corresponding to an inner corner of the outer piezoelectric assembly; and more specifically, each of the third trusses 127 is in connection with and bonded onto the inner surface of two adjacent outer piezoelectric elements 110 corresponding to an inner corner of the outer piezoelectric assembly through the edge guide 130, and the point connecting the third truss 127 with the outer piezoelectric element 110 is preferably an equal diversion point of one third of the outer piezoelectric element. In the present preferable embodiment, the four third trusses 127, functioning as a support beam, can effectively support the external square pipe construction, thereby significantly improve the overall bending and deformation resistance of the piezoelectric actuator 100.

Preferably, adjacent outer piezoelectric elements 110, adjacent inner piezoelectric elements 120, or the outer piezoelectric element 110 and the inner piezoelectric element 120 are in connection with and bonded with each other along their axial-length edges through the edge guide 130, wherein the axial length of the edge guide 130 is identical or substantially the same as the axial length of the outer piezoelectric element 110 and of the inner piezoelectric element 120;

Preferably, the edge guide 130 is made of a polymer material having high yield strength and high breaking strength, which comprises, but is not limited to, polycarbonate and similar polymers. In addition, it shall be underlined that the use of the edge guide 130 is optional.

Preferably, an electrically conductive or non-conductive epoxy glue is employed for the bonding between any two from outer piezoelectric elements 110, inner piezoelectric elements 120 and edge guides 130. Specifically, taking Fig. 1 or Fig. 2 as example, both sides of the edge guide 130 connecting adjacent outer piezoelectric elements 110 are applied with an electrically non-conductive epoxy glue, so as to realize the bonding between the edge guide 130 and the outer piezoelectric element 110. The edge guide 130 connecting adjacent inner piezoelectric elements 120 has a triangular cross section, wherein the three sides of the triangle are respectively applied with an electrically non-conductive epoxy glue, such that the three axial-length edges of the edge guide 130 can be respectively bonded to two inner piezoelectric elements 120 and one outer piezoelectric element 110.

Preferably, the outer piezoelectric elements 110 and the inner piezoelectric elements 120 are of [011]-thickness polarized *d*₃₂ transverse mode single crystals of rectangular shape, of which the [100] crystal direction is in an axial direction of the piezoelectric actuator 100.

Preferably, the outer piezoelectric elements 110 and the inner piezoelectric elements 120 are of [011]-thickness polarized *d*₃₁ transverse mode single crystals of rectangular shape, of which the [0-11] crystal direction is in an axial direction of the piezoelectric actuator 100.

Preferably, the outer piezoelectric elements 110 and the inner piezoelectric elements 120 are relaxor-type solid solution single crystals, wherein the components of the relaxor-type solid solution single crystal include: lead zinc niobate-lead titanate [Pb(Zn_{1/3}Nb_{2/3})O₃-PbTiO₃], lead magnesium niobate-lead titanate [Pb(Mg_{1/3}Nb_{2/3})O₃-PbTiO₃], lead magnesium niobate-lead zirconate titanate [Pb(Mg_{1/3}Nb_{2/3})O₃-PbZrO₃-PbTiO₃], lead indium niobate-lead magnesium niobate-lead titanate [Pb(In_{1/2}Nb_{1/2})O₃-Pb(Mg_{1/3}Nb_{2/3})O₃-PbTiO₃] or derivative components thereof.

Preferably, the piezoelectric actuator 100 further comprises a prestressing mechanism including a stress rod, a disc spring plate and a locknut, wherein the prestressing mechanism is configured such that the outer piezoelectric assembly and the inner piezoelectric assembly are under due compressive stress during use.

Preferably, the piezoelectric actuator 100 further comprises an anti-twist feature, which is composed of a structure of mechanical adaptability and is configured to avoid the twisting of the piezoelectric actuator 100, such that the piezoelectric actuator 100 can move along its axial direction only.

### Second Example

The present example provides an underwater acoustic transducer, which specifically comprises a piston 200, a tail mass 300 and a piezoelectric actuator 100 mentioned in example 1, wherein along an axial direction of the piezoelectric actuator 100, the piston 200 and the tail mass 300 are respectively in connection with both ends of the piezoelectric actuator 100.

The basic working principle of the underwater acoustic transducer provided in the present example is briefly described below: In response to the oscillating voltage, applied to both electrode faces across the thickness of a piezoelectric element, for a transverse mode element, the piezoelectric element is set in resonant oscillation along its active length direction. Ultrasonic radiation will be produced in said length direction of the active element because of the pushing of water through the oscillation of the piezoelectric body.

The underwater acoustic transducer in the present example refers to the piezoelectric actuator 100 in the above-mentioned example, and specifically, the piezoelectric actuator 100 comprises an outer piezoelectric assembly and an inner piezoelectric assembly arranged in the internal of the outer piezoelectric assembly, wherein the inner piezoelectric assembly can achieve a piezoelectric effect while having a supporting function, so as to improve the bending and breakage resistance while contributing to intended oscillation of the piezoelectric actuator 100 and hence enhanced sound power intensity.

The outer piezoelectric assembly in the present invention includes four outer piezoelectric elements 110, which are rectangular piezoelectric single crystal active elements having the same size, successively adjoin each other along their axial-length edges to form a square pipe construction. The inner piezoelectric assembly includes a plurality of inner piezoelectric elements 120, wherein the inner piezoelectric elements 120 are rectangular piezoelectric single crystal active elements having the same size. The cut, the length (axial direction of the piezoelectric actuator 100) and the thickness (radial direction of the piezoelectric actuator 100) of the inner piezoelectric assembly are the same as those of the outer piezoelectric assembly, while the width thereof is smaller than the width of the outer piezoelectric assembly. Moreover, an axial-length edge or an outer surface of the inner piezoelectric assembly is in connection with and bonded onto an inner surface of the outer piezoelectric element 110, so as to realize a mutual support between the outer piezoelectric assembly and the inner piezoelectric assembly, hereby improving the overall bending and breakage resistance of the piezoelectric actuator 100.

### Third Example

It shall be clarified that the first actuator in the following example is equivalent to the outer piezoelectric assembly in the examples mentioned above, and the reinforcement structure is equivalent to the inner piezoelectric assembly in the examples mentioned above.

The actuating device comprises: a first actuator and a reinforcement structure, with the reinforcement structure being arranged within the first actuator.

A first single crystal piezoelectric element (which is equivalent to the outer piezoelectric element in the examples mentioned above) includes an axial-length edge end and a circumferential-length edge end, wherein the axial-length edges of a plurality of single crystal piezoelectric elements successively adjoin each other to form a closed polygonal-pipe construction. Further, the first actuator includes four first single crystal piezoelectric elements, wherein the first actuator is formed by successively adjoining the four single crystal piezoelectric elements along their axial-length edges into a square-pipe construction. In order to further enhance the bending and twisting strength of the first single crystal piezoelectric elements, an edge guide is bonded between adjacent first single crystal piezoelectric elements, such that the edge guide connects the axial-length edges of adjacent first single crystal piezoelectric elements. The edge guide may be a connecting piece made of a high strength polymer material, further, the polymer material for producing the edge guide is preferably polycarbonate.

The piezoelectric reinforcement structure is arranged within the first actuator, and is of an identical axial length of the first actuator, so as its electrically induced displacement in the axial direction is consistent with both axial ends of the first actuator, hereby functioning for better supporting effect. The piezoelectric reinforcement structure may be a second actuator that is able to be arranged within the first actuator, or a single crystal piezoelectric element pair consisting of single crystal piezoelectric elements, or any other reinforcement constructions capable of being arranged within the first actuator for supporting the first actuator, preferably, the constitutive element of the piezoelectric reinforcement structure is a single crystal piezoelectric element, wherein ultrahigh transverse piezoelectric property of the actuating device is assured on condition of supporting the first actuator.

Referring to Fig. 1, the second actuator includes a plurality of second single crystal piezoelectric elements (which is equivalent to the second inner piezoelectric element in the examples mentioned above), and the second single crystal piezoelectric element is also preferably a transverse mode rectangular piezoelectric single crystal, wherein the second single crystal piezoelectric element may be a single crystal piezoelectric element of the same material as that of the first single crystal piezoelectric element, and the second single crystal piezoelectric element has a circumferential length smaller than the circumferential length of the first signal crystal piezoelectric element. The axial-length edges of the plurality of second single crystal piezoelectric elements successively adjoin each other to form a closed polygonal-pipe construction. Further, the second actuator may also include four first single crystal piezoelectric elements, wherein the second actuator is formed by successively adjoining the four second single crystal piezoelectric elements along their axial-length edges into a square-pipe construction. Preferably, an edge guide is used in bonding two respectively adjacent second single crystal piezoelectric elements, so as to further enhance the bending and twisting strength of the actuating device. The relative position relationship between the second actuator and the first actuator may be configured in multiple ways, and any other mounting way that is able to realize stable support of the first actuator can be applied to the present example.

Referring to Fig. 2, a top edge of the second actuator is arranged in parallel with a diagonal line of the first actuator, and a connecting axial-length edge of two respectively adjacent second single crystal piezoelectric elements is attached to a center line of one inner surface of the first actuator such that, when viewed from the top end, the second single crystal piezoelectric elements form a diagonal truss support for improved bending resistance in addition to providing axial reinforcement to the first single crystal piezoelectric element of the first actuator.

Referring to Fig. 3, the circumferential length of the second single crystal piezoelectric element of the second actuator is slightly smaller than the circumferential length of the first single crystal piezoelectric element. The outer side surface of each first single crystal piezoelectric element is attached to the inner surface of one first single crystal piezoelectric element. The four second single crystal piezoelectric elements of the second actuator are relatively better attached to the four first single crystal piezoelectric elements of the first actuator, wherein when viewed from the top end, the second single crystal piezoelectric elements form a diagonal truss support for improved bending resistance in addition to providing axial reinforcement to the single crystal piezoelectric elements of the first actuator.

Referring to Fig. 4, on the basis of the examples mentioned above, the actuating device may further comprises a third actuator, wherein the third actuator (the innermost frame in Fig. 4), the second actuator (the middle frame in Fig. 4) and the first actuator (the outermost frame in Fig. 4) can all be actuators that are of the same construction and material, but have successively decreasing models. The third actuator includes a third single crystal piezoelectric element, wherein the third single crystal piezoelectric element is also preferably a transverse mode rectangular piezoelectric single crystal, the axial length of the third single crystal piezoelectric element is identical with that of the first single crystal piezoelectric element and of the second single crystal piezoelectric element, but the circumferential length of the first single crystal piezoelectric element, the circumferential length of the second single crystal piezoelectric element and the circumferential length of the third single crystal piezoelectric element decrease successively. The above-mentioned two ways can be combined with each other as for the relative position relationships of the third actuator, of the second actuator and of the first actuator. As shown in the figures, a top edge of the second actuator is arranged in parallel with a top edge of the first actuator, and a top edge of the third actuator is arranged in parallel with a diagonal line of the second actuator. Of course, the top edge of the second actuator may also be arranged in parallel with a diagonal line of the first actuator, and the top edge of the third actuator is arranged in parallel with the diagonal line of the second actuator. Any other construction that can realize mutual sleeving and support between the inner actuator and the outer actuator can also be applied to the present example.

Referring to Figs. 5 and 7, an actuating device provided in the present example is shown, comprising a first actuator and a piezoelectric reinforcement structure which is arranged within the first actuator. It differs from the above-mentioned examples in that the piezoelectric reinforcement is a simple pair of single crystal piezoelectric element, which is arranged in the first actuator and is used for stably supporting the first actuator.

Said pair single crystal piezoelectric elements comprises two second single crystal piezoelectric elements arranged opposely, wherein the second single crystal piezoelectric element is the same as the single crystal piezoelectric element provided in the examples mentioned above, and preferably, the two second single crystal piezoelectric elements in said single crystal piezoelectric element pair are arranged in parallel with each other. At least one single crystal piezoelectric element pair and the first actuator may have multiple position relationships relative to each other, which comprise, but are not limited to the three kinds mentioned in the following examples.

Referring to Fig. 5, the circumferential length of the second single crystal piezoelectric element is slightly smaller than the circumferential length of the first single crystal piezoelectric element, and the two second single crystal piezoelectric elements of the single crystal piezoelectric element pair are both arranged in parallel with one top edge of the first actuator. Further, in order to achieve a more stable supporting effect, the center of the single crystal piezoelectric element pair coincides with the center of the first actuator, such that the first actuator and the single crystal piezoelectric element pair are stabilized in one horizontal plane.

Referring to Fig. 6, the circumferential length of the second single crystal piezoelectric element is smaller than the circumferential length of the first single crystal piezoelectric element, and the two second single crystal piezoelectric elements of the single crystal piezoelectric element pair are both arranged in parallel with a diagonal line of the first actuator. Further, in order to achieve a more stable supporting effect, the center of the single crystal piezoelectric element pair coincides with the center of the first actuator, such that the first actuator and the single crystal piezoelectric element pair are stabilized in one horizontal plane.

Referring to Fig. 7, the circumferential length of the second single crystal piezoelectric element is smaller than the circumferential length of the first single crystal piezoelectric element, there are preferably two pairs of single crystal piezoelectric elements, and the top edge of each single crystal piezoelectric element pair is respectively arranged in parallel with one diagonal line of the first actuator. Further, in order to achieve a more stable supporting effect, the centers of the two pairs of single crystal piezoelectric elements both coincide with the center of the first actuator, such that the first actuator and the two pairs of single crystal piezoelectric elements are stabilized in one horizontal plane.

On the basis of the examples mentioned above, an edge guide made of a polymer material may also be bonded at a position where the first single crystal piezoelectric elements axially contacts with the second single crystal piezoelectric elements, hereby further improving the axial bending and twisting strength of the first single crystal piezoelectric elements of the first actuator.

As to the actuating device provided in the examples of the present invention as mentioned above, the piezoelectric reinforcement structure of the actuating device, which is used for axially supporting the first actuator, is preferably of at least one single crystal piezoelectric element pair containing two opposely arranged second single crystal piezoelectric elements, wherein the volume of single crystal material used for the piezoelectric reinforcement structure is reduced to a certain degree, the costs of the actuating device is decreased, while providing adequate axially bending and twisting resistance of the first single crystal piezoelectric elements of the actuating device.

### Fourth Example

The example of a method for producing the actuating device provided in the example mentioned above is described in the following. The method mainly comprises:
Step S1 of successively connecting the axial-length edges of a plurality of first single crystal piezoelectric elements to form a first actuator in a closed polygonal-pipe construction.

The first single crystal piezoelectric element includes an axial-length edge and a circumferential-length edge, the axial-length edges of the plurality of first single crystal piezoelectric elements successively adjoin each other to form a closed polygonal-pipe construction. Further, the first actuator includes four first single crystal piezoelectric elements and is formed by successively adjoining the four second single crystal piezoelectric elements along their axial-length edges into a square-pipe construction.

Step S2 of arranging a piezoelectric reinforcement structure within the first actuator, such that the piezoelectric reinforcement structure supports the first actuator, wherein said reinforcement structure is made of single crystal piezoelectric elements of an identical axial length to the first actuator.

The piezoelectric reinforcement structure is arranged within the first actuator, and the reinforcement structure is made of single crystal piezoelectric elements of an identical axial length to the first actuator, so as to achieve a better supporting effect. The piezoelectric reinforcement structure may be a second actuator capable of being arranged within the first actuator, or single crystal piezoelectric element pair consisting of individual single crystal piezoelectric elements, or any other reinforcement constructions that can be arranged within the first actuator for supporting the first actuator, preferably, the constitutive element of the reinforcement structure is a single crystal piezoelectric element, wherein ultrahigh transverse piezoelectric property of the actuating device is assured on condition of supporting the first actuator.

### Industrial Applicability

The present invention significantly improves the overall bending and breakage resistance of the piezoelectric actuator, and has industrial applicability.

## Claims

1. An axial displacement piezoelectric actuator (100), comprising an outer piezoelectric assembly of square-pipe construction and an inner piezoelectric reinforcement structure such that the outer piezoelectric assembly and the inner piezoelectric reinforcement structure support one another during operation to improve the bending and breaking resistance of the resultant actuator; and
wherein the inner piezoelectric reinforcement structure comprises a plurality of inner active elements (120), either in the form of a square-pipe assembly or truss structures, wherein despite of active elements which make up the inner piezoelectric reinforcement structure having a width smaller than active elements which make up the outer piezoelectric assembly, the cut, axial length and thickness of active elements which make up the inner piezoelectric reinforcement structure are identical to the cut, axial length and thickness of the active elements which make up the outer piezoelectric assembly such that, during operation, the active elements of both the outer piezoelectric assembly and the inner piezoelectric reinforcement structure display the same axial displacement to support one another for the intended reinforcement effect,
**characterized in that** the outer piezoelectric assembly comprises four outer active elements (110) and said four outer active elements successively adjoin each other along their axial-length edges, with the aid of edge guides, to form a square pipe construction;
**in that** the inner piezoelectric reinforcement structure comprises four first inner active elements (121) which successively adjoin each other along their axial-length edges, with the aid of edge guides, to form a first inner square pipe reinforcement structure,
and **in that** the four axial edges of said first inner square pipe reinforcement structure respectively abut, bonded with the aid of edge guides onto, corresponding inner surfaces of the outer piezoelectric assembly, forming diagonal truss support to the outer piezoelectric assembly.

2. The axial displacement piezoelectric actuator (100) according to claim 1, wherein the four outer surfaces of the first inner square-pipe reinforcement structure respectively abut, preferably bonded onto, corresponding inner surfaces of the outer piezoelectric assembly.

3. The axial displacement piezoelectric actuator (100) according to claim 2, wherein the inner piezoelectric reinforcement structure further comprises four second inner active elements (122) which successively adjoin each other along their axial-length edges, with the aid of edge guides, to form a second inner square pipe reinforcement structure,
wherein either the four outer surfaces of said second inner square pipe piezoelectric reinforcement structure respectively abut, preferably bonded onto, corresponding inner surfaces of the first inner square pipe reinforcement structure,
or
wherein the four axial edges of said second square pipe reinforcement structure abut, bonded with the aid of edge guides onto, corresponding inner surfaces of the first inner square pipe reinforcement structure.

4. The axial displacement piezoelectric actuator (100) according to claim 3, wherein the inner piezoelectric reinforcement structure further comprises four third inner active elements (123) and four fourth inner active elements (124),
wherein the four third inner active elements (123) successively adjoin each other along their axial-length edges, with the aid of edge guides, to form a third inner square pipe reinforcement structure, wherein either the four outer surfaces of said third inner square pipe reinforcement structure respectively abut, preferably bonded onto, corresponding inner surfaces of the second inner square pipe reinforcement structure, or the four axial edges of said third inner square pipe reinforcement structure respectively abut, bonded with the aid of edge guides onto, corresponding inner surfaces of the second inner square pipe reinforcement structure;
wherein the four fourth inner active elements (124) successively adjoin each other along their axial-length edges, with the aid of edge guides, to form a fourth inner square pipe reinforcement structure, wherein either the four outer surfaces of said fourth inner square pipe reinforcement structure respectively abut, preferably bonded onto, corresponding inner surfaces of the third inner square pipe reinforcement structure, or the four axial edges of said fourth inner square pipe reinforcement structure respectively abut, bonded with the aid of edge guides onto, corresponding inner surfaces of the third inner square pipe reinforcement structure.

5. The axial displacement piezoelectric actuator (100) according to claim 1 wherein the inner piezoelectric reinforcement structure comprises at least a pair of truss structures (125),
wherein the inner truss structure comprises two parallel trusses having their width aligned parallel to the width of a pair of opposite outer active elements of the outer square pipe piezoelectric assembly, wherein both axial-length edges of each of said two inner trusses (125) respectively abut, bonded with the aid of edge guides onto, the inner surfaces of the other two opposite outer active elements (110) of the outer square pipe piezoelectric assembly (110);
or
wherein the inner truss structure comprises two parallel but diagonally-oriented trusses (126); wherein both axial-length edges of one of said two inner trusses (126) respectively abut, bonded with the aid of edge guides onto, the inner surfaces of two adjacent outer active elements (110), and both axial-length edges of the other one of said two truss structures (126) respectively abut, bonded with the aid of edge guides onto, the inner surfaces of the other two outer active elements of the outer square pipe piezoelectric assembly;
or
wherein the inner truss structure comprises four diagonally-oriented trusses (127); wherein both axial-length edges of each of the four inner trusses (127) respectively abut, bonded with the aid of edge guides onto, two inner surfaces of two adjacent outer active elements (110) that correspond to an inner corner of the outer square pipe piezoelectric assembly.

6. The axial displacement piezoelectric actuator (100) according to any one of claims 1 to 5, wherein the outer active elements (110) and the inner active elements (120) are rectangular-shape single crystals of [011]-thickness polarized *d*₃₂ transverse mode having a [100] crystal direction aligned with the axial direction of the piezoelectric actuator (100).

7. The axial displacement piezoelectric actuator (100) according to any one of claims 1 to 5, wherein the outer active elements (110) and the inner active elements (120) are rectangular-shape single crystals of a [011]-thickness polarized *d*₃₁ transverse mode having a [0-11] crystal direction aligned with an axial direction of the piezoelectric actuator (100).

8. The axial displacement piezoelectric actuator (100) according to any one of claims 1 to 7, wherein the outer active elements (110) and the inner active elements (120) are lead-based relaxor-lead titanate solid solution single crystals, wherein the components of the solid solution single crystals include: lead zinc niobate-lead titanate [Pb(Zn_{1/3}Nb_{2/3})O₃-PbTiO₃], lead magnesium niobate-lead titanate [Pb(Mg_{1/3}Nb_{2/3})O₃-PbTiO₃], lead magnesium niobate-lead zirconate titanate [Pb(Mg_{1/3}Nb_{2/3})O₃-PbZrO₃-PbTiO₃], lead indium niobate-lead magnesium niobate-lead titanate [Pb(In_{1/2}Nb_{1/2})O₃-Pb(Mg_{1/3}Nb_{2/3})O₃-PbTiO₃] or derivatives thereof.

9. The axial displacement piezoelectric actuator (100) accordingly to any one of claims 1 to 8, wherein the edge guides are made of a polymer material comprising, but not limited to, polycarbonate strips.

10. The axial displacement piezoelectric actuator (100) according to any one of claims 1 to 9, wherein the piezoelectric actuator (100) further comprises a prestressing mechanism including a stress rod, a spring assembly and at least one locknut, wherein the prestressing mechanism is configured such that the outer piezoelectric assembly and the inner piezoelectric reinforcement structure are under due compressive stress during operation.

11. The axial displacement piezoelectric actuator (100) according to any one of claims 1 to 10, wherein the piezoelectric actuator (100) further comprises an anti-twist feature, the anti-twist feature having the structure with a mechanical adaptability and the anti-twist feature being configured to be able to avoid twisting of the piezoelectric actuator (100) while allowing the piezoelectric actuator (100) to move freely along its axial direction.

12. An underwater acoustic transducer of which the motor section is made of an axial displacement piezoelectric actuator of claims 1-11, wherein said transducer may further comprise a piston and a tail mass.

13. An array of underwater acoustic transducer of which at least one active element is made of the underwater acoustic transducer of claim 12.

## Patentansprüche

1. Piezoelektrischer Axialverschiebungsaktuator (100), der eine äußere piezoelektrische Anordnung mit einer Vierkantrohrkonstruktion und eine innere piezoelektrische Verstärkungsstruktur umfasst, sodass die äußere piezoelektrische Anordnung und die innere piezoelektrische Verstärkungsstruktur einander während des Betriebs abstützen, um die Biege- und Bruchfestigkeit des resultierenden Aktuators zu verbessern; und
wobei die innere piezoelektrische Verstärkungsstruktur eine Vielzahl von inneren aktiven Elementen (120), entweder in Form einer Vierkantrohranordnung oder von Strebenstrukturen, umfasst, wobei trotz der aktiven Elemente, welche die innere piezoelektrische Verstärkungsstruktur bilden, die eine geringere Breite als die aktiven Elemente aufweisen, welche die äußere piezoelektrische Anordnung bilden, der Schnitt, die axiale Länge und die Dicke der aktiven Elemente, welche die innere piezoelektrische Verstärkungsstruktur bilden, identisch mit dem Schnitt, der axialen Länge und der Dicke der aktiven Elemente sind, welche die äußere piezoelektrische Anordnung bilden, sodass im Betrieb die aktiven Elemente sowohl der äußeren piezoelektrischen Anordnung als auch der inneren piezoelektrischen Verstärkungsstruktur die gleiche axiale Verschiebung aufweisen, um sich gegenseitig für die beabsichtigte Verstärkungswirkung abzustützen,
**dadurch gekennzeichnet, dass** die äußere piezoelektrische Anordnung vier äußere aktive Elemente (110) umfasst und die vier äußeren aktiven Elemente aufeinanderfolgend entlang deren axialen Rändern mit Hilfe von Randführungen aneinander angrenzen, um eine Vierkantrohrkonstruktion zu bilden;
dass die innere piezoelektrische Verstärkungsstruktur vier erste innere aktive Elemente (121) umfasst, die aufeinanderfolgend entlang deren axialen Längsrändern mit Hilfe von Randführungen aneinander angrenzen, um eine erste innere Vierkantrohr-Verstärkungsstruktur zu bilden,
und dass die vier axialen Ränder der ersten inneren Vierkantrohr-Verstärkungsstruktur jeweils an entsprechenden Innenflächen der äußeren piezoelektrischen Anordnung mit Hilfe von Randführungen aufgeklebt anliegen, um eine diagonale Strebenstütze mit der äußeren piezoelektrischen Anordnung zu bilden.

2. Piezoelektrischer Axialverschiebungsaktuator (100) nach Anspruch 1, wobei die vier Außenseiten der ersten inneren Vierkantrohr-Verstärkungsstruktur jeweils an entsprechende Innenseiten der äußeren piezoelektrischen Anordnung vorzugsweise verklebt anliegen.

3. Piezoelektrischer Axialverschiebungsaktuator (100) nach Anspruch 2, wobei die innere piezoelektrische Verstärkungsstruktur ferner vier zweite innere aktive Elemente (122) umfasst, die entlang deren axialen Rändern mit Hilfe von Randführungen aufeinanderfolgend aneinander angrenzen, um eine zweite innere Vierkantrohr-Verstärkungsstruktur zu bilden,
wobei entweder die vier Außenseiten der zweiten inneren piezoelektrischen Vierkantrohr-Verstärkungsstruktur jeweils an entsprechende Innenseiten der ersten inneren Vierkantrohr-Verstärkungsstruktur vorzugsweise verklebt anliegen,
oder
wobei die vier axialen Ränder der zweiten Vierkantrohr-Verstärkungsstruktur an entsprechenden Innenseiten der ersten inneren Vierkantrohr-Verstärkungsstruktur mit Hilfe von Randführungen verklebt anliegen.

4. Piezoelektrischer Axialverschiebungsaktuator (100) (100) nach Anspruch 3, wobei die innere piezoelektrische Verstärkungsstruktur ferner vier dritte innere aktive Elemente (123) und vier vierte innere aktive Elemente (124) umfasst, wobei die vier dritten inneren aktiven Elemente (123) entlang deren axialen Längsrändern mit Hilfe von Randführungen aufeinanderfolgend aneinander angrenzen, um eine dritte innere Vierkantrohr-Verstärkungsstruktur zu bilden, wobei entweder die vier Außenseiten der dritten inneren Vierkantrohr-Verstärkungsstruktur jeweils an entsprechenden Innenflächen der zweiten inneren Vierkantrohr-Verstärkungsstruktur vorzugsweise mit diesen verklebt anliegen, oder die vier axialen Ränder der dritten inneren Vierkantrohr-Verstärkungsstruktur jeweils an entsprechenden Innenseiten der zweiten inneren Vierkantrohr-Verstärkungsstruktur mit Hilfe von Randführungen verklebt anliegen;
wobei die vier vierten inneren aktiven Elemente (124) entlang deren axialen Längsrändern mit Hilfe von Randführungen aufeinanderfolgend aneinander angrenzen, um eine vierte innere Vierkantrohr-Verstärkungsstruktur zu bilden, wobei entweder die vier Außenseiten der vierten inneren Vierkantrohr-Verstärkungsstruktur jeweils an entsprechenden Innenseiten der dritten inneren Vierkantrohr-Verstärkungsstruktur vorzugsweise mit diesen verklebt anliegen, oder die vier axialen Ränder der vierten inneren Vierkantrohr-Verstärkungsstruktur jeweils an entsprechenden Innenseiten der dritten inneren Vierkantrohr-Verstärkungsstruktur mit Hilfe von Randführungen verklebt anliegen.

5. Piezoelektrischer Axialverschiebungsaktuator (100) nach Anspruch 1, wobei die innere piezoelektrische Verstärkungsstruktur zumindest ein Paar von Strebenstrukturen (125) umfasst,
wobei die innere Strebenstruktur zwei parallele Streben umfasst, deren Breite parallel zur Breite eines Paars gegenüberliegender äußerer aktiver Elemente der äußeren piezoelektrischen Vierkantrohranordnung ausgerichtet ist, wobei beide axialen Längsränder einer jeden der beiden inneren Streben (125) jeweils an den Innenseiten der anderen beiden gegenüberliegenden äußeren aktiven Elemente (110) der piezoelektrischen Vierkantrohranordnung mit Hilfe von Randführungen verklebt anliegen;
oder
wobei die innere Strebenstruktur zwei parallele, jedoch diagonal ausgerichtete Streben (126) umfasst; wobei beide axiale Längsränder der einen der beiden inneren Streben (126) jeweils an den Innenseiten zweier benachbarter äußerer aktiver Elemente (110) mit Hilfe von Randführungen verklebt anliegen, und beide axiale Längsränder der anderen der beiden Strebenstrukturen (126) jeweils an den Innenseiten der beiden anderen äußeren aktiven Elemente der piezoelektrischen Vierkantrohranordnung mit Hilfe von Randführungen verklebt anliegen;
oder
wobei die innere Strebenstruktur vier diagonal ausgerichtete Streben (127) umfasst; wobei beide axiale Längsränder einer jede der vier inneren Streben (127) jeweils an zwei Innenseiten zweier benachbarter äußerer aktiver Elemente (110), die einer inneren Ecke der äußeren piezoelektrischen Vierkantrohranordnung entsprechen mit Hilfe von Randführungen verklebt anliegen.

6. Piezoelektrischer Axialverschiebungsaktuator (100) nach einem der Ansprüche 1 bis 5, wobei die äußeren aktiven Elemente (110) und die inneren aktiven Elemente (120) rechteckförmige Einkristalle mit einer [011]-Dicke sind, die im d₃₂-Transversalmodus polarisiert sind und eine [100]-Kristallrichtung aufweisen, die mit der axialen Richtung des piezoelektrischen Aktuators (100) ausgerichtet ist.

7. Piezoelektrischer Axialverschiebungsaktuator (100) nach einem der Ansprüche 1 bis 5, wobei die äußeren aktiven Elemente (110) und die inneren aktiven Elemente (120) rechteckförmige Einkristalle mit einer [011]-Dicke sind, die im d₃₁-Transversalmodus polarisiert sind und eine [0-11]-Kristallrichtung aufweisen, die mit einer axialen Richtung des piezoelektrischen Aktuators (100) ausgerichtet ist.

8. Piezoelektrischer Axialverschiebungsaktuator (100) nach einem der Ansprüche 1 bis 7, wobei die äußeren aktiven Elemente (110) und die inneren aktiven Elemente (120) auf Blei basierende Relaxor-Bleititanat-Einkristalle in fester Lösung sind, wobei die Komponenten der Einkristalle in fester Lösung umfassen: Bleizinkniobat-Bleititanat [Pb(Zn_{1/3}Nb_{2/3})O₃-PbTiO₃], Bleimagnesiumniobat-Bleititanat [Pb(Mg_{1/3}Nb_{2/3})O₃-PbTiO₃], Bleimagnesiumniobat-Bleizirkonattitanat [Pb(Mg_{1/3}N _{2/3})O₃-PbZrO₃-PbTiO₃], Bleiindiumniobat-Bleimagnesiumniobat-Bleititanat [Pb(In_{1/2}Nb_{1/2})O₃-Pb(Mg_{1/3}Nb_{2/3})O₃-PbTiO₃] oder Derivate davon.

9. Piezoelektrischer Axialverschiebungsaktuator (100) nach einem der Ansprüche 1 bis 8, wobei die Randführungen aus einem Polymermaterial hergestellt sind, das Polycarbonatstreifen, jedoch darauf nicht beschränkt, umfasst.

10. Piezoelektrischer Axialverschiebungsaktuator (100) nach einem der Ansprüche 1 bis 9, wobei der piezoelektrische Aktuator (100) ferner einen Vorspannmechanismus mit einem Spannstab, einer Federanordnung und zumindest einer Sicherungsmutter umfasst, wobei der Vorspannmechanismus so konfiguriert ist, dass die äußere piezoelektrische Anordnung und die innere piezoelektrische Verstärkungsstruktur während des Betriebs unter angemessener Druckspannung stehen.

11. Piezoelektrischer Axialverschiebungsaktuator (100) nach einem der Ansprüche 1 bis 10, wobei der piezoelektrische Aktuator (100) ferner eine Verdrehsicherungseinrichtung umfasst, wobei die Verdrehsicherungseinrichtung die Struktur mit mechanischer Anpassungsfähigkeit aufweist und die Verdrehsicherungseinrichtung so konfiguriert ist, dass diese imstande ist, ein Verdrehen des piezoelektrischen Aktuators (100) zu verhindern, während eine freie Bewegung des piezoelektrischen Aktuators (100) entlang seiner axialen Richtung möglich ist.

12. Unterwasserschallwandler, dessen Motorabschnitt aus einem piezoelektrischen Axialverschiebungsaktuator nach einem der Ansprüche 1-11 hergestellt ist, wobei der Wandler ferner einen Kolben und eine Heckmasse umfassen kann.

13. Anordnung von Unterwasserschallwandlern, von denen zumindest ein aktives Element aus dem Unterwasserschallwandler nach Anspruch 12 hergestellt ist.

## Revendications

1. Actionneur piézoélectrique (100) à déplacement axial, comprenant un ensemble piézoélectrique externe de construction tubulaire carré et une structure de renforcement piézoélectrique interne de sorte que l'ensemble piézoélectrique externe et la structure de renforcement piézoélectrique interne se soutiennent mutuellement pendant le fonctionnement pour améliorer la résistance à la flexion et à la rupture de l'actionneur résultant ; et
dans lequel la structure de renforcement piézoélectrique interne comprend une pluralité d'éléments actifs internes (120), soit sous la forme d'un ensemble tubulaire carré ou de structures en treillis, dans lequel malgré le fait que des éléments actifs qui composent la structure de renforcement piézoélectrique interne aient une largeur inférieure à celle des éléments actifs qui composent l'ensemble piézoélectrique externe, la coupe, la longueur axiale et l'épaisseur des éléments actifs qui composent la structure de renforcement piézoélectrique interne sont identiques à la coupe, la longueur axiale et l'épaisseur des éléments actifs qui composent l'ensemble piézoélectrique externe de sorte que, pendant le fonctionnement, les éléments actifs à la fois de l'ensemble piézoélectrique externe et de la structure de renforcement piézoélectrique interne présentent le même déplacement axial pour se soutenir mutuellement pour l'effet de renforcement visé,
**caractérisé en ce que** l'ensemble piézoélectrique externe comprend quatre éléments actifs externes (110) et lesdits quatre éléments actifs externes sont successivement adjacents les uns aux autres sur la longueur de leurs bords axiaux, avec l'aide de guides de bord, pour former une construction tubulaire carré ;
**en ce que** la structure de renforcement piézoélectrique interne comprend quatre premiers éléments actifs internes (121) qui sont successivement adjacents les uns aux autres sur la longueur de leurs bords axiaux , avec l'aide de guides de bord, pour former une première structure de renforcement tubulaire carré interne,
et **en ce que** les quatre bords axiaux de ladite première structure de renforcement tubulaire carré interne viennent respectivement en butée, liés avec l'aide de guides de bord à celles-ci, contre des surfaces internes correspondantes de l'ensemble piézoélectrique externe, formant un support en treillis diagonal à l'ensemble piézoélectrique externe.

2. Actionneur piézoélectrique (100) à déplacement axial selon la revendication 1, dans lequel les quatre surfaces externes de la première structure de renforcement tubulaire carré interne viennent respectivement en butée, de préférence liées à celles-ci, contre des surfaces internes correspondantes de l'ensemble piézoélectrique externe.

3. Actionneur piézoélectrique (100) à déplacement axial selon la revendication 2, dans lequel la structure de renforcement piézoélectrique interne comprend en outre quatre deuxièmes éléments actifs internes (122) qui sont successivement adjacents les uns aux autres sur la longueur de leurs bords axiaux, avec l'aide de guides de bord, pour former une deuxième structure de renforcement tubulaire carré interne,
dans lequel soit les quatre surfaces externes de ladite deuxième structure de renforcement piézoélectrique tubulaire carré interne viennent respectivement en butée, de préférence liées à celles-ci, contre des surfaces internes correspondantes de la première structure de renforcement tubulaire carré interne,
ou
dans lequel les quatre bords axiaux de ladite deuxième structure de renforcement tubulaire carré viennent en butée, liés avec l'aide de guides de bord à celles-ci, contre des surfaces internes correspondantes de la première structure de renforcement tubulaire carré interne.

4. Actionneur piézoélectrique (100) à déplacement axial selon la revendication 3, dans lequel la structure de renforcement piézoélectrique interne comprend en outre quatre troisièmes éléments actifs internes (123) et quatre quatrièmes éléments actifs internes (124),
dans lequel les quatre troisièmes éléments actifs internes (123) sont successivement adjacents les uns aux autres sur la longueur de leurs bords axiaux, avec l'aide de guides de bord, pour former une troisième structure de renforcement tubulaire carré interne, dans lequel soit les quatre surfaces externes de ladite troisième structure de renforcement tubulaire carré interne viennent respectivement en butée, de préférence liées à celles-ci, contre des surfaces internes correspondantes de la deuxième structure de renforcement tubulaire carré interne, ou les quatre bords axiaux de ladite troisième structure de renforcement tubulaire carré interne viennent respectivement en butée, liés avec l'aide de guides de bord à celles-ci, contre des surfaces internes correspondantes de la deuxième structure de renforcement tubulaire carré interne ;
dans lequel les quatre quatrièmes éléments actifs internes (124) sont successivement adjacents les uns aux autres sur la longueur de leurs bords axiaux, avec l'aide de guides de bord, pour former une quatrième structure de renforcement tubulaire carré interne, dans lequel soit les quatre surfaces externes de ladite quatrième structure de renforcement tubulaire carré interne viennent respectivement en butée, de préférence liées à celles-ci, contre des surfaces internes correspondantes de la troisième structure de renforcement tubulaire carré interne, ou les quatre bords axiaux de ladite quatrième structure de renforcement tubulaire carré interne viennent respectivement en butée, liés avec l'aide de guides de bord à celles-ci, contre des surfaces internes correspondantes de la troisième structure de renforcement tubulaire carré interne.

5. Actionneur piézoélectrique (100) à déplacement axial selon la revendication 1, dans lequel la structure de renforcement piézoélectrique interne comprend au moins une paire de structures en treillis (125),
dans lequel la structure en treillis interne comprend deux treillis parallèles dont la largeur est alignée parallèlement à la largeur d'une paire d'éléments actifs externes opposés de l'ensemble piézoélectrique tubulaire carré externe, dans lequel à les bords axiaux de chacun desdits deux treillis (125) internes viennent respectivement en butée, liés avec l'aide de guides de bord à celles-ci, contre les surfaces internes des deux autres éléments actifs externes (110) opposés de l'ensemble piézoélectrique tubulaire carré externe (110) ;
ou
dans lequel la structure en treillis interne comprend deux treillis (126) parallèles, mais orientés en diagonale ;
dans lequel les bords axiaux de l'un desdits deux treillis (126) internes viennent respectivement en butée, liés avec l'aide de guides de bord à celles-ci, contre des surfaces internes de deux éléments actifs externes (110) adjacents, et les bords axiaux de l'autre desdites deux structures en treillis (126) viennent respectivement en butée, liés avec l'aide de guides de bord à celles-ci, contre les surfaces internes des deux éléments actifs externes de l'ensemble piézoélectrique tubulaire carré externe ;
ou
dans lequel la structure en treillis interne comprend quatre treillis (127) orientés en diagonale ; dans lequel les bords axiaux de chacun des quatre treillis (127) internes viennent respectivement en butée, liés avec l'aide de guides de bord à celles-ci, contre deux surfaces internes de deux éléments actifs externes (110) adjacents qui correspondent à un coin interne de l'ensemble piézoélectrique tubulaire carré externe.

6. Actionneur piézoélectrique (100) à déplacement axial selon l'une quelconque des revendications 1 à 5, dans lequel les éléments actifs externes (110) et les éléments actifs internes (120) sont des monocristaux de forme rectangulaire en mode transverse *d₃₂* polarisés suivant l'épaisseur [011] ayant une direction de cristal [100] alignée avec la direction axiale de l'actionneur piézoélectrique (100).

7. Actionneur piézoélectrique (100) à déplacement axial selon l'une quelconque des revendications 1 à 5, dans lequel les éléments actifs externes (110) et les éléments actifs internes (120) sont des monocristaux de forme rectangulaire en mode transverse *d₃₁* polarisés suivant l'épaisseur [011] ayant une direction de cristal [0-11] alignée avec une direction axiale de l'actionneur piézoélectrique (100).

8. Actionneur piézoélectrique (100) à déplacement axial selon l'une quelconque des revendications 1 à 7, dans lequel les éléments actifs externes (110) et les éléments actifs internes (120) sont des monocristaux en solution solide de titanate de plomb-relaxeur à base de plomb, dans lequel les composants des monocristaux en solution solide comportent : du niobate de plomb-zinc-titanate de plomb [Pb(Zn_{1/3}Nb_{2/3})O₃-PbTiO₃], du niobate de plomb-magnésium-titanate de plomb [Pb(Mg_{1/3}Nb_{2/3})O₃-PbTiO₃], du niobate de plomb-magnésium-titanate de zirconate de plomb [Pb(Mg_{1/3}Nb_{2/3})O₃-PbZrO₃-PbTiO₃], du niobate de plomb-indium- niobate de plomb-magnésium-titanate de plomb [Pb(In_{1/2}Nb1/2)O₃-Pb(Mg_{1/3}Nb_{2/3})O₃-PbTiO₃] ou des dérivés de ceux-ci.

9. Actionneur piézoélectrique (100) à déplacement axial selon l'une quelconque des revendications 1 à 8, dans lequel les guides de bord sont fabriqués en un matériau polymère comprenant, mais sans s'y limiter, des bandes de polycarbonate.

10. Actionneur piézoélectrique (100) à déplacement axial selon l'une quelconque des revendications 1 à 9, dans lequel l'actionneur piézoélectrique (100) comprend en outre un mécanisme de précontrainte comportant une tige de contrainte, un ensemble à ressort et au moins un contre-écrou, dans lequel le mécanisme de précontrainte est configuré de sorte que l'ensemble piézoélectrique externe et la structure de renforcement piézoélectrique interne sont sous l'effet d'une contrainte de compression en fonctionnement.

11. Actionneur piézoélectrique (100) à déplacement axial selon l'une quelconque des revendications 1 à 10, dans lequel l'actionneur piézoélectrique (100) comprend en outre un dispositif anti-torsion, le dispositif anti-torsion présentant la structure avec une adaptabilité mécanique et le dispositif anti-torsion étant configuré pour être capable d'éviter une torsion de l'actionneur piézoélectrique (100) tout en permettant à l'actionneur piézoélectrique (100) de se déplacer librement le long de sa direction axiale.

12. Transducteur acoustique sous-marin dont la partie moteur est constituée d'un actionneur piézoélectrique à déplacement axial selon les revendications 1 à 11, dans lequel le transducteur peut en outre comprendre un piston et une masse de queue.

13. Réseau de transducteur acoustique sous-marin dont au moins un élément actif est constitué par le transducteur acoustique sous-marin selon la revendication 12.
